# EUROPÄISCHE PATENTSCHRIFT

(11) **EP 3 041 809 B1**
(45) Veröffentlichungstag und Bekanntmachung des Hinweises auf die Patenterteilung: **03.03.2021**
(21) Anmeldenummer: 14789129.5
(22) Anmeldetag: 03.09.2014
(51) Int. Cl.: C04B 35/447, C04B 35/01, C01B 25/30, C04B 35/52, H01M 6/18, H01M 6/40, C23C 14/34, C04B 35/645, H01J 37/34, H01M 10/052, H01M 10/0562

(54) **LEITFÄHIGES TARGETMATERIAL**
CONDUCTIVE TARGET MATERIAL
MATÉRIAU CIBLE CONDUCTEUR

(30) Priorität: 05.09.2013 AT 2882013 U
(43) Veröffentlichungstag der Anmeldung: 13.07.2016
(73) Patentinhaber: Plansee SE, 6600 Reutte (AT); PLANSEE COMPOSITE MATERIALS GMBH, DE-86983 Lechbruck am See (DE)
(72) Erfinder: POLCIK, Peter, 6600 Reutte (AT); FRANZKE, Enrico, 6600 Reutte (AT); WOLFF, Marcus, 87672 Rosshaupten (DE)
(74) Vertreter: Ciesla, Bettina
(86) Internationale Anmeldenummer: PCT/AT2014/000166
(87) Internationale Veröffentlichungsnummer: WO 2015/031920

(56) Entgegenhaltungen:
- WO-A2-2008/058171
- KR-A- 20030 043 177
- GUNARS BAJARS ET AL: "Physical and electrochemical properties of LiFePO4/C thin films deposited by direct current and radiofrequency magnetron sputtering", SOLID STATE IONICS, Bd. 188, Nr. 1, 1. April 2011 (2011-04-01) , Seiten 156-159, XP055156695, ISSN: 0167-2738, DOI: 10.1016/j.ssi.2010.10.022
- XIANWEI GUO ET AL: "Capacitive Energy Storage on Fe/Li 3 PO 4 Grain Boundaries", JOURNAL OF PHYSICAL CHEMISTRY C, Bd. 115, Nr. 9, 10. März 2011 (2011-03-10) , Seiten 3803-3808, XP055156762, ISSN: 1932-7447, DOI: 10.1021/jp111015j

## Beschreibung

Die vorliegende Erfindung betrifft ein leitfähiges Targetmaterial enthaltend im Wesentlichen eine Lithiumverbindung, bevorzugt Lithiumphosphat, und Kohlenstoff sowie übliche Verunreinigungen. Weiterhin betrifft die Erfindung ein Verfahren zur Herstellung eines leitfähigen Targetmaterials sowie dessen Verwendung.

Targetmaterialien aus Lithiumverbindungen wie zum Beispiel Lithiumphosphat (Li₃PO₄), Lithium-Lanthan-Zirkonoxid (Li₇La₃Zr₂O₁₂) oder auch andere Li-enthaltende Verbindungen wie zum Beispiel Li₃P, Li₂O, Li₃N, LiBO₂, Li₂SO₄, Lil oder LiBP oder auch Verbundwerkstoffe die Li-Verbindungen enthalten, beispielsweise Li₂SO₄-SiS₂-P₂S₅, werden in Anlagen für die physikalische Dampfabscheidung (PVD, "physical vapor deposition") zur Abscheidung von Lithium-Ionen Elektrolyt-Schichten verwendet. Solcherart abgeschiedene Schichten finden Anwendung in der Herstellung von Dünnschichtbatterien, wobei die abgeschiedenen Lithium-Ionen Elektrolyt-Schichten eine sehr geringe elektrische Leitfähigkeit aufweisen, vorzugsweise elektrisch isolierend sein sollen. Ihre Eignung als Elektrolyt-Schichten ergibt sich aus ihrer Leitfähigkeit für Ionen.

In der Regel geschieht die Abscheidung solcher Lithium-Ionen Elektrolyt-Schichten mittels eines RF/HF ("radio frequency"/Hochfrequenz)-Reaktivsputterprozesses, so bilden sich zum Beispiel beim Sputtern eines Lithiumphosphat-Targets unter der Beteiligung von Stickstoff und oder Sauerstoff während des Abscheidevorganges stickstoffhaltige LiPON-Schichten aus, die eine hohe lonenleitfähigkeit besitzen. Herkömmliche einphasige Targetmaterialien aus Lithiumverbindungen, im Speziellen Lithiumphosphat, und ihre Verwendung zur Herstellung von Lithium-Ionen Elektrolyt-Schichten werden zum Beispiel in der WO 2008 58171 A2 beschrieben.

Ebenso können natürlich auch weitere Typen von Lithium-Ionen Elektrolyt-Schichten über die Abscheidung von entsprechenden Targetmaterialien hergestellt werden.

Die KR20030043177A beschreibt in Absatz [0056] die Herstellung von Elektrolyt-Schichten durch Sputtern oder Dampfabscheidung von lonenleitern wie Li₃PO₄, LiPO₃, LiBO₂ oder LiO₂.

Die geringe elektrische Leitfähigkeit von herkömmlichen Targetmaterialien aus Lithiumverbindungen wie zum Beispiel Lithiumphosphat (Li₃PO₄), schränkt jedoch die Verwendung von DC ("direct current")- und gepulsten DC-Sputterverfahren stark ein und limitiert damit die erzielbaren Abscheideraten der erzeugten Lithium-Ionen Elektrolyt-Schichten. Vollständig isolierende Targetmaterialien können über DC- und gepulstes DC-Sputtern nicht abgeschieden werden.

Leitfähige Targetmaterialien die in Folge auch in DC- oder gepulsten DC-Sputterverfahren eingesetzt werden können sind etwa aus der WO 2007 042394 A1 bekannt, in der eine Verwendung von Dotierungselementen, insbesondere Silber, Zinn, Zink, Bismut und Antimon in keramischen Targetmaterialien beschrieben ist.

Der Nachteil einer Dotierung mit metallischen Elementen ist jedoch, dass ein großer Aufwand betrieben werden muss, um zu verhindern, dass diese Elemente beim Abscheiden der Schicht nicht in diese eingebaut werden und dadurch elektrische Leitung in der Schicht möglich wird. So kann zum Beispiel eine gesonderte selektive Abscheidung des metallischen Elements oder auch von während des Sputterprozesses entstehenden Verbindungen desselben an gekühlten Platten oder Scheiben nötig sein.

Ein Verfahren zur Herstellung von Lithium-Ionen Elektrolyt-Schichten über die Bereitstellung von im Wesentlichen leitfähigen Targetmaterialien ist in der US 2009 0159433 A1 beschrieben. Darin werden Targets, bestehend aus mehreren verschiedenen Lithium- und/oder Phosphorverbindungen (zum Beispiel Li₃P, Li₃N oder auch P₂O₃), in einem Reaktivsputterprozess (DC, gepulstes DC, AC oder RF) mit Sauerstoff und Stickstoff abgetragen und so eine Lithium-Ionen Elektrolyt-Schicht erzeugt. Die erwünschte Zusammensetzung der erzeugten dünnen Schicht muss hierbei sowohl über die Verhältnisse der unterschiedlichen einzelnen chemischen Verbindungen im Targetmaterial, als auch über das Verhältnis von Sauerstoff zu Stickstoff in der Sputteratmosphäre eingestellt werden. Dies führt in weiterer Folge zu einer hohen Komplexität bei der Wahl der Prozessparameter, als auch bei der Herstellung des entsprechenden Targetmaterials, was wiederum hohe Kosten nach sich zieht.

Bei der Verwendung von mehreren unterschiedlichen chemischen Verbindungen im Targetmaterial besteht außerdem die Gefahr eine Schicht mit inhomogenen Eigenschaften abzuscheiden. Dies ist vor allem für die geforderte gleichbleibende ionische Leitfähigkeit solcher Lithium-Ionen Elektrolyt-Schichten nachteilig. Zusätzlich ist durch das Vorliegen mehrerer chemischer Verbindungen mit unterschiedlichen thermischen Leitfähigkeiten und/oder thermischen Ausdehnungskoeffizienten eine verringerte Thermoschockbeständigkeit gegeben, die sich in weiterer Folge negativ auf die mechanische Festigkeit des Targetmaterials auswirken kann.

Ein weiterer Nachteil bei der Verwendung mehrerer unterschiedlicher chemischer Verbindungen in einem Targetmaterial ist das Auftreten unterschiedlicher Sputterraten der verschiedenen Verbindungen. Dadurch kann die Abscheidung von Schichten mit konstanter Dicke erschwert werden.

Dementsprechend besteht die Aufgabe der vorliegenden Erfindung darin, ein leitfähiges Targetmaterial bereitzustellen das zur Abscheidung von Lithium-Ionen Elektrolyt-Schichten mittels DC oder gepulstem DC Sputtern geeignet ist.

Die erwünschte chemische Zusammensetzung der abzuscheidenden Schicht soll einfach einzustellen und homogen über die Schicht sein. Zusätzlich soll das leitfähige Targetmaterial eine hohe Thermoschockbeständigkeit aufweisen, sowie hohe Prozessstabilität und in Folge geringe Kosten gewährleisten. Die erwähnten Nachteile sollen vermieden werden.

Die Aufgabe wird durch ein leitfähiges Targetmaterial gemäß Anspruch 1 sowie durch ein Verfahren zum Herstellen eines leitfähigen Targetmaterials gemäß Anspruch 10 gelöst. Vorteilhafte Weiterbildungen der Erfindung ergeben sich aus den Unteransprüchen.

Ein erfindungsgemäßes leitfähiges Targetmaterial enthält im Wesentlichen Li₃PO₄ Kohlenstoff sowie übliche Verunreinigungen. Der enthaltene Kohlenstoff tritt überwiegend, mit einem Anteil größer 50%, in elementarer Form auf.

Als im Wesentlichen Li₃PO₄ ist hier zu verstehen, dass das Targetmaterial hauptsächlich Li₃PO₄ das bevorzugt einen an einer Schnittfläche des Targetmaterials gemessenen Flächenanteil von größer gleich 80% einnimmt.

Für die Bestimmung des an einer Schnittfläche des leitfähigen Targetmaterials gemessenen Flächenanteils der im Wesentlichen Li₃PO₄ Lithiumverbindung wird ein metallographischer Schliff hergestellt und licht- oder elektronenmikroskopisch untersucht. Mittels kommerziell erhältlicher Bildauswertesoftwares können an so erzeugten mikroskopischen Aufnahmen Flächenanalysen durchgeführt werden. Dies erfolgt über eine Bildanalyse zur Bestimmung einzelner Phasenanteile des genannten Gefüges typischerweise über eine Kontrastierung der zu unterscheidenden Phasen.

Die Lithiumverbindung Lithiumphosphat (Li₃PO₄) hat sich als besonders vorteilhaft für die Verwendung in einem erfindungsgemäßen leitfähigen Targetmaterial herausgestellt da damit besonders hohe Abscheideraten bei der Herstellung von Lithium-Ionen Elektrolyt-Schichten erzielt werden können.

Weiter bevorzugt ist es, wenn der in einem erfindungsgemäßen leitfähigen Targetmaterial enthaltene Kohlenstoff mit einem Anteil größer 75% in elementarer Form auftritt.

Weiter bevorzugt ist es, wenn der enthaltene Kohlenstoff mit einem Anteil größer 90% in elementarer Form auftritt.

Weiter bevorzugt ist es, wenn der enthaltene Kohlenstoff mit einem Anteil größer 95% in elementarer Form auftritt.

Weiter bevorzugt ist es, wenn der enthaltene Kohlenstoff mit einem Anteil größer 99% in elementarer Form auftritt.

Besonders bevorzugt ist es, wenn der enthaltene Kohlenstoff ausschließlich, mit vernachlässigbaren in Lithiumphosphat, gelösten Anteilen, in elementarer Form auftritt.

Mit üblichen Verunreinigungen werden herstellbedingte Verunreinigungen an Gasen oder begleitenden Elementen bezeichnet, die aus den verwendeten Rohstoffen stammen. Der Anteil solcher Verunreinigungen in einem erfindungsgemäßen leitfähigen Targetmaterial liegt im Bereich von unter 1000 ppm. Geeignete Verfahren zur chemischen Elementanalyse sind bekanntlich abhängig vom zu analysierenden chemischen Element. Für die chemische Analyse eines erfindungsgemäßen leitfähigen Targetmaterials wurden ICP-OES (Optische Emissionsspektrometrie mit induktiv gekoppeltem Plasma), RFA (Röntgenfluoreszenzanalyse) und GDMS (Glow Discharge Mass Spectrometry) verwendet.

Als elementare Form des Kohlenstoffs wird hier reiner Kohlenstoff, zum Beispiel in Form von Graphit, bezeichnet. Der in einem erfindungsgemäßen leitfähigen Targetmaterial enthaltene Kohlenstoff wird also bevorzugt wenig oder nur in zu vernachlässigendem Ausmaß in Lithiumphosphat, gelöst und bildet auch keine oder nur vernachlässigbar kleine Mengen an zusätzlichen chemischen Verbindungen.

Weitere Erscheinungsformen elementaren Kohlenstoffs sind beispielsweise Diamant, Fullerene oder auch amorpher Kohlenstoff, aber auch andere Kristallstrukturen und sp²:sp³-Hybridisierungsverhältnisse sind als elementarer Kohlenstoff im Sinne der vorliegenden Erfindung zu betrachten.

Durch die elementare Form des in einem erfindungsgemäßen Targetmaterial enthaltenen Kohlenstoffs werden die zuvor beschriebenen Nachteile mehrerer unterschiedlicher chemischer Verbindungen im Targetmaterial vermieden.

Der Kohlenstoff bildet in einem erfindungsgemäßen Targetmaterial also eine separate Komponente der Mikrostruktur und ist nicht hauptsächlich Bestandteil einer anderen Komponente der Mikrostruktur. Durch diese Ausprägung des Kohlenstoffs ergibt sich die signifikant erhöhte elektrische Leitfähigkeit eines erfindungsgemäßen leitfähigen Targetmaterials.

Als Anteil des in elementarer Form auftretenden Kohlenstoffs ist hier das Verhältnis zum gesamten im Targetmaterial enthaltenen Kohlenstoff zu verstehen.

Je höher der Anteil des in elementarer Form auftretenden Kohlenstoffs, desto höher ist die mit einem bestimmten Kohlenstoffgehalt (zum Beispiel in at%) in einem erfindungsgemäßen Targetmaterial erreichbare elektrische und thermische Leitfähigkeit.

Ein erfindungsgemäßes leitfähiges Targetmaterial enthält bevorzugt mindestens einen perkolierenden Kohlenstoff-Cluster von einer Seite des Targetmaterials zu einer gegenüberliegenden Seite des Targetmaterials.

Ein derartiger perkolierender Kohlenstoff-Cluster ist verantwortlich für die gegenüber einem herkömmlichen Targetmaterial ohne einen perkolierenden Kohlenstoff-Cluster signifikant erhöhte elektrische Leitfähigkeit, da entlang des mindestens einen perkolierenden Kohlenstoff-Clusters elektrischer Strom von einer Seite des leitfähigen Targetmaterials zu einer anderen Seite des leitfähigen Targetmaterials fließen kann.

Ein solcher perkolierender Kohlenstoff-Cluster ist als Teil des gesamten in einem erfindungsgemäßen Targetmaterial enthaltenen Kohlenstoffs zu verstehen und besteht folglich bevorzugt aus elementarem Kohlenstoff.

Perkolierende Cluster sind ein zentraler Begriff aus der Perkolationstheorie, die dem Fachmann als Möglichkeit der Beschreibung von Phänomenen wie beispielsweise elektrische Leitfähigkeiten von Legierungen bekannt ist. Ein Cluster wird als perkolierend bezeichnet, wenn er gegenüberliegende Ränder des einbettenden Raumes verbindet.

Ein erfindungsgemäßes leitfähiges Targetmaterial weist eine bevorzugt zweiphasige Mikrostruktur auf, in welcher Kohlenstoff netzwerkartig um Lithiumphosphat-reiche Bereiche, angeordnet ist.

Unter Mikrostruktur ist hier die Anordnung der spezifischen Komponenten (Phasen) des Targetmaterials zu verstehen, welche auch als Gefüge bezeichnet werden kann. Die Mikrostruktur eines Materials kann nach üblichen Methoden mittels Lichtmikroskop oder Rasterelektronenmikroskop (REM) zum Beispiel nach Anfertigen eines metallographischen Schliffes sichtbar gemacht werden.

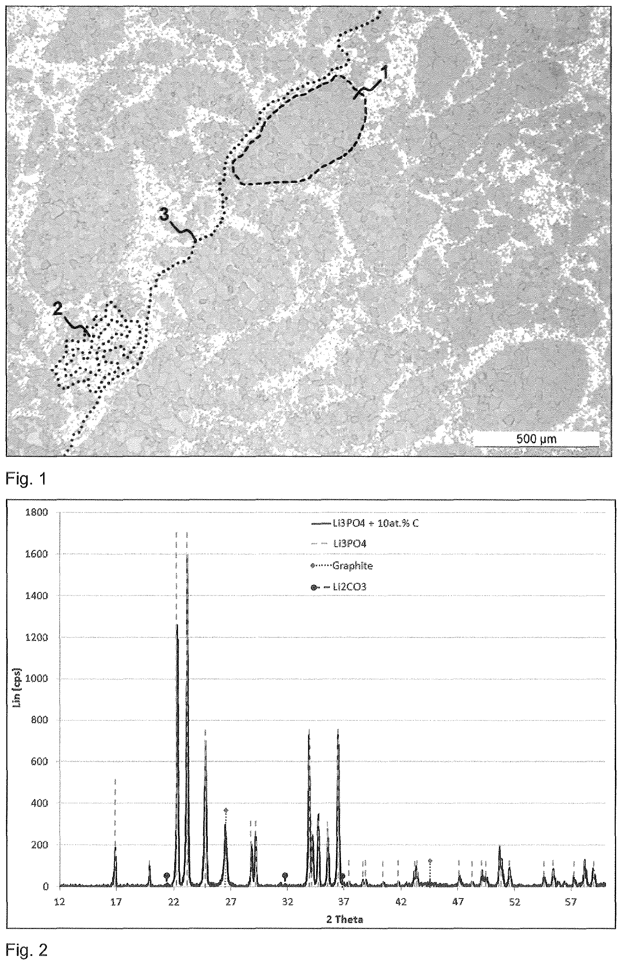

In Figur 1 ist beispielhaft eine lichtmikroskopische Aufnahme der Mikrostruktur eines erfindungsgemäßen leitfähigen Targetmaterials dargestellt. Erkennbar sind: An im Wesentlichen einer Lithiumverbindung-reiche Bereiche, in diesem Fall Lithiumphosphat-reiche Bereiche 1, Bereiche elementaren Kohlenstoffs 2, sowie ein dem Bildausschnitt entsprechender Teil eines perkolierenden Kohlenstoff-Clusters 3.

Unter zweiphasig ist hier zu verstehen, dass mindestens zwei voneinander unterschiedliche Komponenten (Phasen), charakterisiert durch unterschiedliche chemische Zusammensetzung und/oder Kristallstruktur im erfindungsgemäßen leitfähigen Targetmaterial vorliegen. Im Fall eines erfindungsgemäßen leitfähigen Targetmaterials enthaltend im Wesentlichen Lithiumphosphat, und Kohlenstoff sowie übliche Verunreinigungen stellt Lithiumphosphat, die erste Phase und elementarer Kohlenstoff die zweite Phase der bevorzugt zweiphasigen Mikrostruktur dar. Geringe Anteile an üblichen Verunreinigungen sind hier nicht als weitere Phasen in Bezug auf die bevorzugt zweiphasige Mikrostruktur des erfindungsgemäßen leitfähigen Targetmaterials zu verstehen. In Ausführungsformen der Erfindung kann die Mikrostruktur eines leitfähigen Targetmaterials neben Lithiumphosphat, und Kohlenstoff auch geringe Anteile an weiteren Lithiumverbindungen, wie zum Beispiel Lithiumcarbonat (Li₂CO₃) enthalten. Solche Verbindungen können in geringer Menge sowohl bereits im Ausgangspulver vorhanden sein, als sich auch im Laufe des Herstellverfahrens, zum Beispiel bei der Verdichtung bilden. Auch solche geringen Anteile weiterer Lithiumverbindungen sind nicht als weitere Phasen in Bezug auf die bevorzugt zweiphasige Mikrostruktur des erfindungsgemäßen leitfähigen Targetmaterials zu verstehen.

Das Auftreten solcher Verbindungen kann gegebenenfalls mittels Röntgendiffraktometrie (XRD) unter Verwendung der relevanten JCPDS-Karten nachgewiesen oder ausgeschlossen (unter Berücksichtigung der jeweiligen röntgenographischen Nachweisgrenze) werden. Auch das Vorliegen der bevorzugt zweiphasigen Mikrostruktur kann mit dieser Methode bestimmt werden.

In Figur 2 ist beispielhaft eine Phasenbestimmung mittels Röntgendiffraktion (XRD) eines erfindungsgemäßen leitfähigen Targetmaterials (verwendete JCPDS-Karten: Li₃PO₄: 00-015-0760; Kohlenstoff (Graphit) 00-023-0064; Li₂CO₃: 00-022-1141) dargestellt.

In einem erfindungsgemäßen leitfähigen Targetmaterial liegen also mindestens zwei voneinander unterscheidbare Komponenten (Phasen) vor. Der Großteil der Mikrostruktur besteht aus Lithiumphosphat, welches bei Betrachtung in einem Mikroskop als homogene flächig ausgebildete Bereiche auftritt.

Um diese flächig ausgebildeten Bereiche ist elementarer Kohlenstoff netzwerkartig angeordnet, wobei als Netzwerk hier eine vorzugsweise zusammenhängende Ausbildung des Kohlenstoffs bezeichnet wird. Inwieweit sich dieses Netzwerk beim Herstellprozess ausbildet, kann über die Wahl der Korngrößen der verwendeten Ausgangspulver, sowie den durchgeführten Mischvorgang beeinflusst werden.

Weiters hat auch der Gehalt (zum Beispiel in at%) an zugegebenem Kohlenstoff in Kombination mit den verwendeten Korngrößen der Ausgangspulver Einfluss auf die Ausbildung des Netzwerkes und die räumliche - und damit sichtbare flächige - Ausdehnung der sich bildenden Bereiche an Lithiumphosphat-Bereiche, sowie Kohlenstoff-Bereiche.

So wird zum Beispiel bei gleichbleibendem Kohlenstoffgehalt die Ausbildung eines Netzwerks erschwert, je geringer die Korngröße der Ausgangspulver, des Lithiumphosphats, gewählt wird.

Üblicherweise wird die Mikrostruktur eines erfindungsgemäßen leitfähigen Targetmaterials an zweidimensionalen Schnitten durch das dreidimensionale Targetmaterial analysiert. Die dreidimensionale Mikrostruktur eines erfindungsgemäßen leitfähigen Targetmaterials ist im Wesentlichen isotrop, das heißt, es liegen keine oder im Wesentlichen keine Unterschiede der Mikrostruktur in Bezug auf die Betrachtungsebene bzw. keine Richtungsabhängigkeit der Materialeigenschaften vor.

Ein erfindungsgemäßes leitfähiges Targetmaterial weist bevorzugt einen an einer Schnittfläche des Targetmaterials gemessenen Flächenanteil an Kohlenstoff zwischen 3 und 20% auf.

Für die Bestimmung des an einer Schnittfläche des leitfähigen Targetmaterials gemessenen Flächenanteils an Kohlenstoff wird ein metallographischer Schliff hergestellt und licht- oder elektronenmikroskopisch untersucht. Mittels kommerziell erhältlicher Bildauswertesoftwares können an so erzeugten mikroskopischen Aufnahmen Flächenanalysen durchgeführt werden. Dies erfolgt über eine Bildanalyse zur Bestimmung einzelner Phasenanteile des genannten Gefüges typischerweise über eine Kontrastierung der zu unterscheidenden Phasen.

Liegt der an einer Schnittfläche des Targetmaterials gemessene Flächenanteil an Kohlenstoff unter 3% werden die erwünschten elektrischen Leitfähigkeiten des Targetmaterials nicht mehr optimal erreicht. Ein weiterer Nachteil von zu geringen Kohlenstoff Flächenanteilen von unter 3% ist eine verringerte Prozessfähigkeit, vor allem bei einer Herstellung über Spark Plasma Sintern (SPS).

Flächenanteile von über 20% an Kohlenstoff führen bereits zu erhöhtem Einbau von Kohlenstoff in die mittels eines leitfähigen Targetmaterials abgeschiedene Schicht. Dadurch kann es sein, dass die erwünschten Schichteigenschaften nicht mehr optimal erreicht werden können.

Weiter bevorzugt ist ein an einer Schnittfläche des erfindungsgemäßen leitfähigen Targetmaterials gemessener Flächenanteil an Kohlenstoff von 5 bis 15%. In diesem Bereich sind die erreichbaren Eigenschaftskombinationen besonders vorteilhaft und es können eine besonders hohe Leistungseinbringung und Abscheiderate erzielt werden. Insbesondere wird dies durch eine in diesem bevorzugten Bereich des gemessenen Flächenanteils an Kohlenstoff optimierte Wärmeabfuhr während des Sputterprozesses gewährleistet.

Ein erfindungsgemäßes leitfähiges Targetmaterial enthält vorzugsweise zwischen 3 und 20 at% Kohlenstoff.

Der Kohlenstoffgehalt in at% eines erfindungsgemäßen leitfähigen Targetmaterials wird über eine Umrechnung in wt% und die Einwaage der entsprechenden Pulvermengen eingestellt. Am fertigen Targetmaterial kann der Kohlenstoffgehalt in at% über eine Heißgasextraktion (auch: Verbrennungsanalyse) überprüft, beziehungsweise nachgewiesen werden. Dabei wird der enthaltene Kohlenstoff bei Temperaturen von <1600°C in einem Aluminiumoxidtiegel im Sauerstoffstrom verbrannt und in Form seiner Oxide mittels Infrarotzelle bestimmt.

Bei Kohlenstoffgehalten unter 3 at% ist bereits eine reduzierte Prozessfähigkeit bei der Herstellung, insbesondere bei einer Fertigung mittels Spark Plasma Sintern (SPS) möglich. Bei Kohlenstoffgehalten von über 20 at% kann es bereits zu erhöhtem Einbau von Kohlenstoff in die mittels eines leitfähigen Targetmaterials abgeschiedene Schicht kommen. Dadurch kann es sein, dass die erwünschten Schichteigenschaften nicht mehr optimal erreicht werden können.

Weiter bevorzugt sind Kohlenstoffgehalte im erfindungsgemäßen leitfähigen Targetmaterial von 5 bis 15 at%. Ab Gehalten von etwa 5 at% ist die erzielte elektrische Leitfähigkeit bereits so hoch, dass eine 5 bis 10-fache Erhöhung der Abscheiderate erreicht werden kann. Bei zusätzlicher Optimierung des Sputterprozesses kann auch noch eine weitere Erhöhung der erreichbaren Abscheideraten möglich sein.

Durch die Zugabe von Kohlenstoff in den beschriebenen Gehalten wird zudem die Temperaturleitfähigkeit (auch bezeichnet als thermische Leitfähigkeit) der Pulvermischung während der Herstellung eines erfindungsgemäßen leitfähigen Targetmaterials eingestellt und damit eine bessere Kompaktierbarkeit erreicht.

Die elektrische Leitfähigkeit eines erfindungsgemäßen leitfähigen Targetmaterials beträgt bevorzugt mindestens 0,01 S/mm.

Durch eine elektrische Leitfähigkeit von bevorzugt mindestens 0,01 S/mm ist gewährleistet, dass das Targetmaterial mittels eines DC- oder gepulsten DC-Sputterverfahren abgeschieden werden kann. Dabei können Abscheideraten erzielt werden, die das 5 bis 10-fache jener in RF-Sputterverfahren erreichten betragen. Die für die Abscheidung einer Lithium-Ionen Elektrolyt-Schichten mit bestimmter geforderter Dicke nötigen Zeiten können dadurch stark reduziert und damit die entstehenden Kosten drastisch gesenkt werden.

Weiter bevorzugt ist eine elektrische Leitfähigkeit des erfindungsgemäßen leitfähigen Targetmaterials von mindestens 0,02 S/mm.

Damit können die erzielten Abscheideraten weiter gesteigert und die Kosten für einen Abscheideprozess weiter gesenkt werden.

Die elektrische Leitfähigkeit kann einfach mit handelsüblichen Geräten mittels Transportmessung, beispielsweise einer Vierpunktmessung bestimmt werden und beschreibt die Fähigkeit eines Materials, elektrischen Strom zu leiten.

Die Temperaturleitfähigkeit eines erfindungsgemäßen leitfähigen Targetmaterials beträgt bevorzugt mindestens 2,5 mm²/s.

Durch diese im Vergleich zu reinen Lithiumverbindungen, beispielsweise Lithiumphosphat (Li₃PO₄), erhöhte Temperaturleitfähigkeit eines erfindungsgemäßen leitfähigen Targetmaterials ist eine höhere Leistungseinbringung während des Sputterprozesses möglich, da die im Targetmaterial entstehende Temperatur schneller abgeführt werden kann und die sich im Targetmaterial einstellende Temperatur erniedrigt wird.

Weiter bevorzugt ist eine Temperaturleitfähigkeit eines erfindungsgemäßen leitfähigen Targetmaterials von mindestens 3 mm²/s, da damit die Leistungseinbringung ins Targetmaterial noch weiter erhöht werden kann. Diese Werte für die Temperaturleitfähigkeit gelten für Raumtemperatur. Typischerweise verringert sich die Temperaturleitfähigkeit mit steigender Temperatur. Es ist jedoch weiter vorteilhaft wenn auch bei typischen Einsatztemperaturen eines erfindungsgemäßen leitfähigen Targetmaterials zwischen etwa 100 und 250°C die Temperaturleitfähigkeit desselben mindestens 1,5 mm²/s beträgt.

Die Temperaturleitfähigkeit kann einfach mittels Laser-Flash-Methode bestimmt werden und ist die Eigenschaft eines bestimmten Materials, die die zeitliche Veränderung der räumlichen Verteilung der Temperatur durch Wärmeleitung als Folge eines Temperaturgefälles beschreibt.

Ein erfindungsgemäßes leitfähiges Targetmaterial weist bevorzugt einen thermischen Ausdehnungskoeffizienten von zwischen 10 bis 20 ppm/K auf.

Dieser Wertebereich wird sowohl bei Raumtemperatur, als auch bei typischen Einsatztemperaturen eines erfindungsgemäßen Targetmaterials von etwa 100 bis 250°C erreicht. Im Vergleich dazu weist beispielsweise reines einphasiges Lithiumphosphat (Li₃PO₄) einen thermischen Ausdehnungskoeffizienten von etwa 2 ppm/K bei Raumtemperatur auf, der auch bei erhöhten Temperaturen nicht signifikant gesteigert wird.

Der erhöhte thermische Ausdehnungskoeffizient eines erfindungsgemäßen leitfähien Taretmaterials ist angepasst an jenen typischer Materialien für Stützelemente, zum Beispiel einer Rückplatte aus Kupfer (thermischer Ausdehungskoeffizient von Kupfer etwa 16 ppm/K). Durch diese Anpassung des thermischen Ausdehnungskoeffizienten wird eine erhöhte Thermoschockbeständigkeit und Thermowechselbeständigkeit des Targetmaterials während des Einsatzes gewährleistet. Zudem wird ein Abplatzen des Targetmaterials nach einer optionalen Verbindung mit einem Stützelement (optionaler Bonding-Schritt) dadurch weitestgehend vermieden.

Der thermische Ausdehnungskoeffizient eines erfindungsgemäßen Targetmaterials kann einfach mittels Dilatometermessung bestimmt werden.

Ein weiterer Vorteil der optimierten thermischen Eigenschaften eines erfindungsgemäßen Targetmaterials ist die damit ermöglichte Verwendung von höher schmelzenden Lotmaterialien wie beispielsweise Sn für eine Verbindung (optionaler Bonding-Schritt) mit einem Stützelement. Dadurch kann die Leistungseinbringung beim Sputterprozess noch weiter erhöht werden.

Die relative Dichte eines erfindungsgemäßen leitfähigen Targetmaterials liegt bevorzugt bei mindestens 95%. Weiter bevorzugt ist eine relative Dichte von mindestens 99%. Je höher die relative Dichte des leitfähigen Targetmaterials, desto vorteilhafter sind dessen Eigenschaften. Targetmaterialien mit relativen Dichten von unter 95% weisen ein poröses Gefüge auf, das als virtuelles Leck, sowie als Quelle von Verunreinigungen wirken kann. Zusätzlich neigen Targetmaterialien mit zu geringer relativer Dichte dazu, Wasser und andere Verunreinigungen aufzunehmen was in weiterer Folge zu einem schwerer kontrollierbaren Abscheideprozess führen kann.

Die relative Dichte kann bekanntlich einfach über das archimedische Prinzip mittels Auftriebsverfahren bestimmt werden.

Die mechanische Festigkeit eines erfindungsgemäßen leitfähigen Targetmaterials ist bevorzugt ausreichend hoch, um eine mögliche mechanische Bearbeitung im Zuge des Herstellverfahrens zu gewährleisten. Ein erfindungsgemäßes leitfähiges Targetmaterial ist bevorzugt für eine Verwendung zur Abscheidung einer Lithium-Ionen Elektrolyt-Schicht für eine Dünnschichtbatterie vorgesehen.

Durch die vorgesehene Verwendung zur Abscheidung einer Lithium-Ionen Elektrolyt-Schicht für eine Dünnschichtbatterie in unterschiedlichen Fertigungsanlagen sowie für unterschiedliche Geometrien der zu beschichtenden Substrate werden verschiedene geometrische Anforderungen an ein erfindungsgemäßes leitfähiges Targetmaterial gestellt. Demzufolge kann ein solches in Form einer Platte, einer Scheibe, einer Stange, eines Rohrs oder eines anderen komplex geformten dreidimensionalen Körpers vorliegen. Ein solcher komplex geformter Körper kann beispielsweise die Form eines Topfes oder einer Hohlkathode aufweisen.

Die mit einem erfindungsgemäßen Targetmaterial abgeschiedenen Lithium-Ionen Elektrolyt-Schichten sollen eine nur sehr geringe elektrische Leitfähigkeit aufweisen, beziehungsweise vorzugsweise elektrisch isolierend sein. Die Eignung einer solchen Schicht als Elektrolyt ergibt sich aus ihrer lonenleitfähigkeit. Demnach darf der in einem erfindungsgemäßen leitfähigen Targetmaterial enthaltene Kohlenstoff nicht, oder im Wesentlichen nicht, in die abgeschiedene Schicht eingebaut werden. Bevorzugt wird der enthaltene Kohlenstoff durch den in Restgasen in der Sputteratmosphäre enthaltenen Sauerstoff in Form von CO oder CO₂ abgebunden und in Folge abgepumpt. Noch weiter reduziert kann der Kohlenstoffgehalt in der abgeschiedenen Schicht beispielsweise durch einen optionalen Reaktiv-Sputter-Schritt werden. Dadurch wird die Funktion der mit einem erfindungsgemäßen Targetmaterial abgeschiedenen Lithium-Ionen Elektrolyt-Schichten nicht durch den im Targetmaterial enthaltenen Kohlenstoff beeinträchtigt.

Ein Verfahren zur Herstellung eines erfindungsgemäßen leitfähigen Targetmaterials aus Li₃PO₄ und Kohlenstoff sowie üblichen Verunreinigungen enthält folgende Schritte:
- Herstellen einer Pulvermischung aus im Wesentlichen Li₃PO₄ und Kohlenstoff
- Einfüllen der Pulvermischung in eine Form
- Verdichten der Pulvermischung durch Druck und/oder Temperatur.

Die Herstellung einer Pulvermischung für ein erfindungsgemäßes leitfähiges Targetmaterial erfolgt durch die Einwaage der benötigten Pulvermengen und Mischen in einem geeigneten Mischaggregat bis eine homogene Verteilung der Komponenten in der Pulvermischung gewährleistet ist.

Die so hergestellte Pulvermischung wird in eine Form gefüllt, die entsprechend des nachfolgenden Verdichtungsschrittes verschiedene dreidimensionale Abmessungen aufweisen sowie aus unterschiedlichen Materialien hergestellt sein kann. Typische Materialien für solche Formen sind zum Beispiel Graphit, CFC (Kohlenstofffaserverstärkte Kohlenstoffe), Mo oder TZM (Titan-Zirkon-Molybdän).

Die in eine Form gefüllte Pulvermischung wird sodann verdichtet, der Verdichtungsschritt kann sowohl durch Druck, durch Temperatur oder auch durch Druck und Temperatur erfolgen.

Geeignete Verfahren für den Verdichtungsschritt sind beispielsweise Heißpressen und Spark Plasma Sintern (SPS), es sind jedoch auch noch andere Verdichtungsverfahren möglich.

Weitere mögliche Schritte die in einem Verfahren zur Herstellung eines erfindungsgemäßen leitfähigen Targetmaterials optional enthalten sein können sind:
- Durchführen eines Trocknungsschrittes des Pulvers und/oder der Pulvermischung
- Mechanische Bearbeitung
- Bonding des bearbeiteten Rohlings auf ein oder mehrere Stützelemente:

Durch ein Trocknen des Pulvers und/oder der Pulvermischung, insbesondere des eingesetzten Pulvers der im Wesentlichen einen Lithiumverbindung, bevorzugt also des Lithiumphosphatpulvers, wird gewährleistet, dass erfahrungsgemäß in kommerziell erhältlichem Pulver enthaltenes Kristallwasser abgebaut, und damit der Sauerstoffgehalt des Pulvers und in weiterer Folge der Pulvermischung reduziert wird. Dadurch ist eine präzisere Kontrolle der chemischen Zusammensetzung des leitfähigen Targetmaterials, und damit auch der in Folge damit abgeschiedenen Lithium-Ionen Elektrolyt-Schicht möglich. Eine Optimierung der für den Trocknungsschritt erforderlichen optimalen Temperatur kann zum Beispiel über die Durchführung einer thermogravimetrischen Messung erfolgen.

Nach dem Verdichten der Pulvermischung über Druck und/oder Temperatur kann eine mechanische Bearbeitung des erhaltenen Rohlings erforderlich sein. Ein derartiger Bearbeitungsschritt hat bevorzugt trocken zu erfolgen, da bei einer Nassbearbeitung ein zumindest oberflächlicher Angriff des Rohlings stattfinden könnte. Durch eine derartige mechanische Bearbeitung, zum Beispiel über Drehen, Fräsen oder Schleifen können sowohl die Endgeometrie des leitfähigen Targetmaterials eingestellt oder präzisiert, als auch zum Beispiel eine bestimmte gewünschte Rauigkeit der Oberfläche desselben eingestellt werden.

Eine solche mechanische Bearbeitung kann wie bereits beschrieben nach dem Verdichten der Pulvermischung zu einem Rohling, als auch nach einem optionalen Bonding-Schritt sowie als Endbearbeitung durchgeführt werden.

Ein erfindungsgemäßes leitfähiges Targetmaterial kann weiters durch einen Bonding-Schritt mit einem oder mehreren entsprechenden Stützelementen, zum Beispiel einer Rückplatte oder einem Stützrohr verbunden werden. Solche Stützelemente können zum Beispiel aus Cu, Cu-Legierungen, Ti oder Ti-Legierungen gefertigt sein. Es sind aber auch andere Materialien für die Herstellung entsprechender Stützelemente verwendbar. Für einen solchen Bonding-Schritt werden bevorzugt Elemente oder Legierungen mit niedrigem Schmelzpunkt, zum Beispiel Indium verwendet. Zusätzlich kann optional ein Haftvermittler, zum Beispiel WNi, verwendet werden, um eine bessere Benetzung zu gewährleisten.

Der Verdichtungsschritt in einem Verfahren zur Herstellung eines erfindungsgemäßen leitfähigen Targetmaterials erfolgt bevorzugt über Heißpressen (HP) oder Spark Plasma Sintern (SPS). Es sind jedoch auch andere Verdichtungsverfahren wie zum Beispiel Heißisostatischpressen (HIP) oder Kaltisostatischpressen (CIP) und nachfolgendes Sintern möglich.

Bei einer Verdichtung mittels SPS erfolgt die Verdichtung der in eine entsprechende Form gefüllten Pulvermischung über Druck und Temperatur, wobei eine Aufheizung auf Sintertemperatur direkt in der Form durch die Einleitung von elektrischem Strom erfolgt.

Vorteile der Verwendung von SPS für den Verdichtungsschritt sind eine drastische Verkürzung der notwendigen Sinterzeit, sowie dass kein vor dem Sintern erzeugter Grünling erforderlich ist.

Bevorzugt findet eine Verdichtung mittels SPS eines erfindungsgemäßen leitfähigen Targetmaterials bei Temperaturen zwischen 700 und 900°C statt. Dies schließt jedoch eine Verdichtung bei Temperaturen unter- oder oberhalb des angegebenen Bereichs nicht aus.

Bevorzugt findet eine Verdichtung mittels SPS eines erfindungsgemäßen Targetmaterials bei Drücken zwischen 10 und 60 bar statt. Dies schließt jedoch eine Verdichtung bei Drücken unter- oder oberhalb des angegebenen Bereichs nicht aus.

Bei einer Verdichtung mittels HP erfolgt die Verdichtung der in die Form gefüllten Pulvermischung über Druck und Temperatur, wobei eine Aufheizung auf Sintertemperatur über eine beheizte Form, beispielsweise eine Graphitform erfolgt.

Bevorzugt findet eine Verdichtung mittels HP eines erfindungsgemäßen leitfähigen Targetmaterials zwischen 700 und 900°C statt. Dies schließt jedoch eine Verdichtung bei Temperaturen unter- oder oberhalb des angegebenen Bereichs nicht aus.

Bevorzugt findet eine Verdichtung mittels HP eines erfindungsgemäßen Targetmaterials bei Drücken zwischen 10 und 60 bar statt. Dies schließt jedoch eine Verdichtung bei Drücken unter- oder oberhalb des angegebenen Bereichs nicht aus.

Die für die Verdichtung nötige Zeit ist abhängig von den Abmessungen des jeweils hergestellten leitfähigen Targetmaterials und kann einfach über eine Zyklusoptimierung im Zuge der Implementierung des Verdichtungsprozesses ermittelt werden.

Weitere Vorteile und Zweckmäßigkeiten der Erfindung ergeben sich anhand der nachfolgenden Beschreibung von Ausführungsbeispielen unter Bezugnahme auf die beigefügten Figuren.

### Von den Figuren zeigen:

- Fig. 1: Mikrostruktur eines erfindungsgemäßen leitfähigen Targetmaterials, lichtmikroskopische Aufnahme. Erkennbar sind: Bereiche reich an im Wesentlichen einer Lithiumverbindung, in diesem Fall Lithiumphosphat-reiche Bereiche 1, Bereiche elementaren Kohlenstoffs 2, sowie ein dem Bildausschnitt entsprechender Teil eines perkolierenden Kohlenstoff-Clusters 3
- Fig. 2: Phasenbestimmung mittels Röntgendiffraktion (XRD) eines erfindungsgemäßen leitfähigen Targetmaterials (verwendete JCPDS-Karten: Li₃PO₄: 00-015-0760; Kohlenstoff (Graphit) 00-023-0064; Li₂CO₃: 00-022-1141)

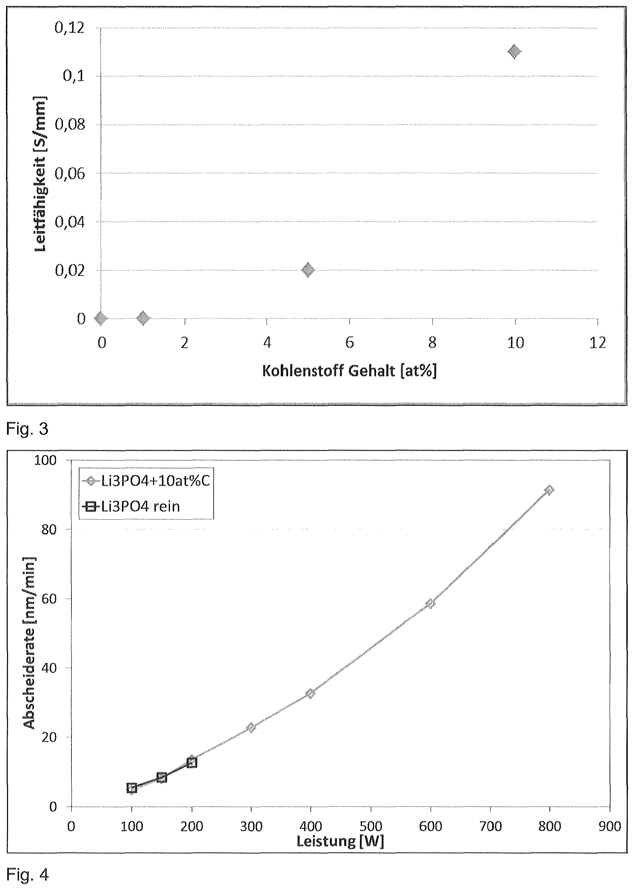

- Fig. 3: Leitfähigkeit [S/mm] vs. Gehalt an eingebrachtem Kohlenstoff [at%] eines erfindungsgemäßen Targetmaterials
- Fig. 4: Vergleich von Abscheiderate und Leistungseinbringung des erfindungsgemäßen leitfähigen Targetmaterials zum Stand der Technik

### Ausführungsbeispiele

### Beispiel 1

Lithiumphosphatpulver mit einer über das Volumen gewichteten durchschnittlichen Korngröße von 3,64 µm (D50=3,09 µm, D90=6,81 µm) wurde mit 5 at% Kohlenstoffpulver mit einer über das Volumen gewichteten durchschnittlichen Korngröße von 3,88 µm (D50= 3,49µm, D90=6,81 µm) in einem Turbula-Mischer für 30 min vermischt. Die so erhaltene Pulvermischung wurde in die Graphitform einer Heißpresse gefüllt und darin bei einer Temperatur von 875°C und einer Presskraft von etwa 3 MPa für 2 h unter Ar-Atmosphäre zu einem Targetmaterial mit den Abmessungen 261 x 241 mm und 10 mm Dicke verdichtet. Das so erhaltene Targetmaterial wurde mittels Sandstrahlen gereinigt und darauffolgend auf Endgeometrie trockenbearbeitet. Mittels eines Bonding-Schrittes auf eine Rückplatte aus Kupfer wurde ein fertiges Target hergestellt.

### Beispiel 2

Lithiumphosphatpulver mit einer über das Volumen gewichteten durchschnittlichen Korngröße von 3,64 µm (D50=3,09 µm, D90=6,81 µm) wurde mit 10 at% Kohlenstoffpulver mit einer über das Volumen gewichteten durchschnittlichen Korngröße von 3,88 µm (D50= 3,49µm, D90=6,81 µm) in einem Turbula-Mischer für 30 min vermischt. Die so erhaltene Pulvermischung wurde in die Graphitform einer Spark Plasma Sinteranlage (SPS) gefüllt und darin unter einem Druck von 20 bar und bei einer Temperatur von 875°C die über 1 h gehalten wurde zu einem scheibenförmigen Targetmaterial mit einem Durchmesser von 73,5 mm und einer Dicke von 5 mm verdichtet. Das so erhaltene Targetmaterial wurde darauffolgend mittels eines Trockenbearbeitungsschrittes überschliffen und mittels eines Bonding-Schrittes auf eine Rückplatte aus Kupfer zu einem fertigen Target verarbeitet.

### Beispiel 3

Mit einem Target aus einem erfindungsgemäßen leitfähigen Targetmaterial, hergestellt analog zu Bsp.1 und 2, enthaltend Lithiumphosphat und Kohlenstoff (10 at%) wurde zur Ermittlung der Abscheiderate ein DC-Sputterversuch unter Ar-Atmosphäre (Druck 7,5*10⁻³ mbar) bei einer Leistungseinbringung von 10 W/cm² Targetmaterial durchgeführt. In einer Zeit von 990 s konnte eine Schichtdicke von 1,5 µm erzielt werden. Eine Messung der elektrischen Leitfähigkeit dieser Schicht mittels Vierpunktmessung ergab keine messbare Leitfähigkeit.

## Patentansprüche

1. Leitfähiges Targetmaterial geeignet zur Abscheidung von Lithium-Ionen Elektrolyt-Schichten mittels DC oder gepulstem DC Sputtern, enthaltene
hauptsächlich Lithiumphosphat (Li₃PO₄) und Kohlenstoff sowie übliche Verunreinigungen, wobei der enthaltene Kohlenstoff überwiegend, mit einem Anteil größer 50%, in elementarer Form auftritt.

2. Leitfähiges Targetmaterial nach einem der vorangehenden Ansprüche, **dadurch gekennzeichnet, dass** das Targetmaterial mindestens einen perkolierenden Kohlenstoff-Cluster von einer Seite des Targetmaterials zu einer gegenüberliegenden Seite des Targetmaterials enthält.

3. Leitfähiges Targetmaterial nach einem der vorangehenden Ansprüche, **dadurch gekennzeichnet, dass** das Targetmaterial eine zweiphasige Mikrostruktur aufweist, in welcher Kohlenstoff netzwerkartig um Lithiumphosphat-reiche Bereiche, angeordnet ist.

4. Leitfähiges Targetmaterial nach einem der vorangehenden Ansprüche, **dadurch gekennzeichnet, dass** das Targetmaterial einen an einer Schnittfläche des Targetmaterials gemessenen Flächenanteil an Kohlenstoff zwischen 3 und 20% aufweist.

5. Leitfähiges Targetmaterial nach einem der vorangehenden Ansprüche, **dadurch gekennzeichnet, dass** es zwischen 3 und 20 at% Kohlenstoff enthält.

6. Leitfähiges Targetmaterial nach einem der vorangehenden Ansprüche, **dadurch gekennzeichnet, dass** die elektrische Leitfähigkeit des Targetmaterials mindestens 0,01 S/mm beträgt.

7. Leitfähiges Targetmaterial nach einem der vorangehenden Ansprüche, **dadurch gekennzeichnet, dass** die Temperaturleitfähigkeit des Targetmaterials mindestens 2,5 mm²/s beträgt.

8. Leitfähiges Targetmaterial nach einem der vorangehenden Ansprüche, **dadurch gekennzeichnet, dass** es einen thermischen Ausdehnungskoeffizienten von zwischen 10 bis 20 ppm/K aufweist.

9. Verwendung eines leitfähigen Targetmaterials nach einem der vorangehenden Ansprüche zur Abscheidung einer Lithium-Ionen Elektrolyt-Schicht zur Herstellung einer Dünnschichtbatterie.

10. Verfahren zur Herstellung eines leitfähigen Targetmaterials nach Anspruch 1 wobei das Verfahren folgende Schritte enthält:
- Herstellen einer Pulvermischung enthaltend Lithiumphosphat (Li₃PO₄) und Kohlenstoff
- Einfüllen der Pulvermischung in eine Form
- Verdichten der Pulvermischung durch Druck und/oder Temperatur.

11. Verfahren zur Herstellung eines leitfähigen Targetmaterials nach Anspruch 10, **dadurch gekennzeichnet, dass** der Verdichtungsschritt über Heißpressen (HP) oder Spark Plasma Sintern (SPS) erfolgt.

## Claims

1. Conductive target material suitable for deposition of lithium ion electrolyte layers by means of DC or pulsed DC sputtering, comprising essentially lithium phosphate (Li₃PO₄) and carbon, and also typical impurities, wherein the carbon present occurs predominantly, with a proportion of greater than 50%, in elemental form.

2. Conductive target material according to claim 1, **characterized in that** the target material comprises at least one carbon cluster that percolates from one side of the target material to an opposite side of the target material.

3. Conductive target material according to any of the preceding claims, **characterized in that** the target material has a biphasic microstructure in which carbon is arranged in the manner of a network around the lithium phosphate-rich regions.

4. Conductive target material according to any of the preceding claims, **characterized in that** the target material has a proportion of carbon by area, measured on a cut surface of the target material, of between 3% and 20%.

5. Conductive target material according to any of the preceding claims, **characterized in that** it contains between 3 and 20 at% of carbon.

6. Conductive target material according to any of the preceding claims, **characterized in that** the electrical conductivity of the target material is at least 0.01 S/mm.

7. Conductive target material according to any of the preceding claims, **characterized in that** the thermal conductivity of the target material is at least 2.5 mm²/s.

8. Conductive target material according to any of the preceding claims, **characterized in that** it has a coefficient of thermal expansion of between 10 and 20 ppm/K.

9. Use of a conductive target material according to any of the preceding claims for deposition of a lithium ion electrolyte layer for a thin-film battery.

10. Process for producing a conductive target material according to claim 1, wherein the process comprises the following steps:
- producing a powder mixture comprising lithium phosphate (Li₃PO₄) and carbon
- introducing the powder mixture into a mould
- compacting the powder mixture by means of pressure and/or temperature.

11. Process for producing a conductive target material according to claim 10, **characterized in that** the compaction step is effected by means of hot pressing (HP) or spark plasma sintering (SPS).

## Revendications

1. Matériau cible conducteur approprié pour le dépôt de couches d'électrolyte d'ions lithium au moyen d'une pulvérisation DC ou DC pulsée, contenant principalement du phosphate de lithium (Li₃PO₄) et du carbone ainsi que des impuretés habituelles, le carbone contenu étant présent majoritairement, en une proportion supérieure à 50 %, sous forme élémentaire.

2. Matériau cible conducteur selon revendication 1, **caractérisé en ce que** le matériau cible contient au moins un agrégat de carbone percolant d'une face du matériau cible vers une face opposée du matériau cible.

3. Matériau cible conducteur selon l'une quelconque des revendications précédentes, **caractérisé en ce que** le matériau cible présente une microstructure biphasique, dans laquelle du carbone est disposé tel un réseau autour de zones riches en phosphate de lithium.

4. Matériau cible conducteur selon l'une quelconque des revendications précédentes, **caractérisé en ce que** le matériau cible présente une proportion de surface, mesurée au niveau d'une section du matériau cible, de carbone compris entre 3 et 20 %.

5. Matériau cible conducteur selon l'une quelconque des revendications précédentes, **caractérisé en ce qu'**il contient entre 3 et 20 % at. de carbone.

6. Matériau cible conducteur selon l'une quelconque des revendications précédentes, **caractérisé en ce que** la conductivité électrique du matériau cible est d'au moins 0,01 S/mm.

7. Matériau cible conducteur selon l'une quelconque des revendications précédentes, **caractérisé en ce que** la conductivité en température du matériau cible est d'au moins 2,5 mm²/s.

8. Matériau cible conducteur selon l'une quelconque des revendications précédentes, **caractérisé en ce qu'**il présente un coefficient de dilatation thermique compris entre 10 et 20 ppm/K.

9. Utilisation d'un matériau cible conducteur selon l'une quelconque des revendications précédentes pour le dépôt d'une couche d'électrolyte d'ions lithium pour la préparation d'une pile en couche mince.

10. Procédé pour la préparation d'un matériau cible conducteur selon la revendication 1, le procédé contenant les étapes suivantes :
- préparation d'un mélange de poudres contenant du phosphate de lithium (Li₃PO₄) et du carbone
- remplissage d'un moule avec le mélange de poudres
- compactage du mélange de poudres sous pression et/ou température.

11. Procédé pour la préparation d'un matériau cible conducteur selon la revendication 10, **caractérisé en ce que** l'étape de compactage est réalisée par l'intermédiaire d'un pressage à chaud (HP) ou d'un frittage flash (SPS).
